# EUROPEAN PATENT SPECIFICATION

(11) **EP 0 560 815 B1**
(45) Date of publication and mention of the grant of the patent: **31.08.1994**
(21) Application number: 91920571.6
(22) Date of filing: 29.11.1991
(51) Int. Cl.: G11C 27/02, H03F 1/30, H03H 19/00, H03M 1/06

(54) **METHOD FOR CLOCKFEEDTHROUGH ERROR COMPENSATION IN SWITCHED CAPACITOR CIRCUITS**
VERFAHREN ZUR TAKTDURCHFÜHRUNGSFEHLERKOMPENSATION IN SCHALTUNGEN MIT GESCHALTETEN KAPAZITÄTEN
PROCEDE DE COMPENSATION D'ERREUR DE TRAVERSEE DE SYNCHRONISATION DANS DES CIRCUITS DE CONDENSATEUR COMMUTES

(30) Priority: 03.12.1990 IT 2227090
(43) Date of publication of application: 22.09.1993
(73) Proprietor: ITALTEL SOCIETA ITALIANA TELECOMUNICAZIONI s.p.a., 20149 Milano (IT)
(72) Inventor: COPPERO, Luciana, I-27100 Pavia (IT); PALMISANO, Giuseppe, I-27100 Pavia (IT)
(74) Representative: Giustini, Delio
(86) International application number: EP9102257
(87) International publication number: WO9209990

(56) References cited:
- IEEE JOURNAL OF SOLID-STATE CIRCUITS. Vol. 20, no.4, August 1985, NEW YORK US pages 837-844 PM VAN PETEGHEM ET AL. 'Micropower High-Performance SC Building Block for Integrated Low-Level Signal Processing' see page 838, left column, line 30 - page 838, right column, line 4 figure 1
- IEEE JOURNAL OF SOLID-STATE CIRCUITS. Vol. 25, no- 3, June 1990, NEW YORK US pages 644-651; JJJ HASPESLAGH ET AL.: 'ATotal Solution for a 9600 b-s Modem Transmitter chip' see page 647, left column, line 5 - page 647, left column, line 37; figures 4,6
- IEEE JOURNAL OF SOLID-STATE CIRCUITS vol. 24 no. 4, August 1989, NEW YORK US pages 1143-1146 C. EICHENBERGER ET AL.: 'Dummy Transistor Compensation of Analog MOS Switches' see page 1144, right column, line 30 see page 1145, right column, line 22 - page 1145, right column, line 36
- PATENT ABSTRACTS OF JAPAN vol. 10, no. 213 (E-422)(2269) 25 July 1986 & JP A 61 052 018 (HITACHI) 14 March 1986 see abstract; figure

## Description

The present invention concerns a method for the compensation of errors deriving from the so-called clockfeedthrough, which represents one of the essential factors limiting the accuracy obtained from switched capacity circuits, such as A/D and D/A converters.

The clockfeedthrough effect causes for instance the PSRR (Power Supply Rejection Rate) degrading, in switched capacitor filters, being a particularly serious effect when the operating frequency exceeds one hundred kHz. To this purpose we mention the article by P.M. Van Peteghem, "On the relationship between PSRR and clockfeedthrough in SC filters", IEEE Journal of Solid State Circuits, Vol. 23, August 1988.

Also, this effect is one of the essential causes for the offset error in comparators, of the offset and gain error in amplifiers and in sample and hold circuits.

The clockfeedthrough effect consists of the injection of parasitic electric charges in the signal paths, being this injection caused by the opening of transistor made switches, according to the MOS technology.

As already known, a MOS transistor holds in its own channel the mobile charges when it is on, that is when conducting. When it is switched off, said mobile charge is injected in the nodes which the same switch is connected to.

In the final phase of switching off, when the gate voltage reaches the threshold value beyond which the channel is fully empty, a capacitive partition of the control or clock signal occurs, through the overlap capacitances existing between the gate and the source and drain transistor terminals, and the external capacitances connected to these terminals.

When the switch is connected to one high impedance node, such as for instance the virtual ground of an operating amplifier, the input of a comparator, of a sample and hold block or similar, the parasitic charge is stored in the high impedance node, is added to the useful signal and originates an error voltage.

The magnitude of this error depends on electric and technological factors, such as the gate voltage falling rate the signal level at which the switch is biased before opening, the substrate doping, the switch dimensions. Some mathematical analyses of those dependences, have been described for instance in the article by B. J. Shen and C. Hu "Switch-induced error voltage on a switched capacitor", IEEE Journal of Solid State Circuits, Vol. SC-19, No. 4, August 1984, and in the article by D. Mc Quigg "Residual charge on a switched capacitor", IEEE Journal of Solid State Circuits, Vol. SC-18, No. 6 December 1983.

Some methods or circuits aimed to reduce the clockfeedthrough error voltage have been proposed.

For instance, in the article of R. Suarez, P. Gray and D. Hodges, "All-MOS charge redistribution analog-to-digital conversion techniques - Part II", IEEE Journal of Solid State Circuits, Vol. SC-10, 1975, a proposal was made for the use of a so called "dummy switch", having short-circuited source and drain terminals, connected in series to the useful switch. This switch is driven by a clock signal, inverted with respect to the clock of the useful switch, and gives rise to a partial compensation of the parasitic charge injected.

However, bias conditions, the clock signal and the inverted clock signal slopes and the impedance to which the two switched are subjected, can never be absolutely identical for the dummy switch and for the useful one, and this originates a difference in the parasitic charge quantity injections, with an ensuing limitation of the obtainable compensation level.

A partial improvement can be obtained by varying the transistors' size ratio, but this technique is difficult to be applied because the ratio optimum value is difficult to predict.

Two types of clockfeedthrough error can be identified:
a non linearity error, caused by switches connected to signal sources in such a way that the error size depends on the signal value, and
an offset error originated on the contrary by switches always switched among fix reference voltages.

To reduce the signal dependent clockfeedthrough error, in the article of D.G. Haigh ad B. Singh, "A switching scheme for SC filters which reduces the effect of parasitic capacitances associated with switch control terminals", Procs, ISCAS, May 1983, a technique has been proposed suggesting a suitable timing for the opening of switches which have to be turned off in the same clock phase.

According to this technique the opening of switches connected to the signal is the last one, when a closed path from the injection or integration capacitors to a low impedance does not exist any more the clockfeedthrough charge is therefore only injected on the parasitic capacitances which, in the subsequenc clock phase, are discharged through the low impedance signal source, thus not making any reading error. This technique is therefore aimed at compensating the charge depending on the signal while, as it shall be furtherly described more in detail, purpose of the present invention is to compensate the offset error. The compensation method proposed by Haigh and Singh is applicable to both single ended and fully differential configurations.

On the contrary, for the offset error originated by a switch opening on a virtual ground, which is always connected to the analog ground voltage, there is no technique allowing to carry out efficient compensation in the case of differential structures has been already proposed.

In fact the above mentioned article by Suarez et. al., uses an additional switch injecting a parasitic charge in the same capacitance node where the error charge is deposited, however, this method requires the closing of the supplementary switch simultaneously to the opening of the useful switch. Therefore the compensation takes place in a transient way, with substantial limitations and troubles concerning for e.g. the control phases skew and sizing difficulties. According to the invention the parasitic charge is on the contrary compensated in a static way, by subtraction to the charge already deposited in the capacitive node, due to the previous opening of the compensation switch.

Another compensation technique is proposed by K. Martin in the article "New clockfeedthrough cancellation technique for analogue MOS switched capacitor circuits" in Electronic Letters, No. 18, 1982, but it is applicable only to single ended circuits since it employs an additional compensation circuitry connected to the operational amplifier positive terminal. This technique consists of reproducing the parasitic charge injection on the operational amplifier positive terminal, adding a capacitors and switches network repeating the existing one on the negative terminal.

This method requires a good matching between the two network, so that the clockfeedthrough error results in a common mode voltage and is therefore partially rejected by the CMRR (Common Mode Rejection Ratio) of the amplifier.

Besides the limited applicability to single ended circuits, major drawbacks of the method are the dependence on the effectiveness of CMRR compensation of single ended stages and the amount of capacitive area due to the addition of the switched capacitor network on the positive input.

In fact, since this method carries out a voltage compensation, the capacitor added to the positive terminal must have a value equal to the total capacitance connected to the negative terminal, generally having a high value.

Finally, the article of K. Watanabe and S. Ogawa "Clockfeedthrough compensated sample/hold circuits", Electronics Letters, September 1988 describes a method for the compensation of the clockfeedthrough error originated by a signal voltage (and not by an offset voltage) applicable only where a unit gain device or buffer is used.

According to this previous method in fact, the additional switch injects a parasitic charge in the feedback capacitor which performs a subtraction compensation of the charge injected by the useful switch in the subsequent phase. Actually the two switches (the useful and the compensation ones) are turned off in two different clock signal phases, and therefore they are not subjected to the same terminal condition when opening, but those terminal condition are affected by the variation of the input signal from one clock phase to the other one.

Aim of the present invention is to propose a method for the clockfeedthrough offset error cancellation, applicable to fully differential structured circuits, overcoming the troubles and limits mentioned above for the general techniques of clockfeedthrough error compensation.

According to the invention as characterized in the appended claim, in fully differential structures, in the particular case where the same phase sequence is used in the two switched capacity networks (SC), belonging to the two branches of the differential structure, switches are simultaneously turned off and therefore, disregarding the capacitance load mismatch on the clock lines and the mismatch between the two SC structures, the clockfeedthrough offset error acts as a common mode signal, and therefore the operational amplifier CMRR carries out a partial reduction.

The method allows the compensation of the residual offset error in a simple and effective way and, in some cases, it allows to take advantages of elements already present in the circuit and therefore it does not require additional elements.

Those targets are obtained with the invention consisting of a method for the offset error compensation deriving from the injection of a clockfeedthrough charge in a high impedance node of a fully differential operational amplifier and including capacitors periodically switched through at least one useful electronic switch biased at a given reference voltage, characterized by the fact to involve, for each branch of the differential structure, the early opening, with respect to said useful switch, of an additional switch biased at the same reference voltage to inject on at least one capacitance of the same capacitor path a parking charge substantially equal and opposed to the one subsequently injected after the opening of the useful switch.

The method consists of the advanced opening, compared to a useful switch (called also clockfeedthrough switch since its opening originates the clockfeedthrough charge injection in a virtual ground), of another switch biased at the same reference voltage. This early opening injects in the same capacitance path a parking charge which shall be compensated, by nullifying the same, by the parasitic charge subsequently injected by the clockfeedthrough switch.

In general, the network made of this additional switch and the capacitance through which the charge injected by the same flows towards the virtual ground, has to be added to the switched capacitor structure actually useful for the conversion or filtering or sampling operations carried out by the considered circuit.

The method according to the invention performs a charge compensation instead of a voltage one, and the additional capacitor can therefore have a value lower than the one of the useful capacitor, with a consequent reduction of the area required for the supplementary capacitor. The increase of capacitance area consequent to the application of the method results therefore greatly reduced.

Furthermore in different capacitor structures, a similar network is already present in the circuit, that is it is possibile to identify a capacitor and a switch suitable to perform the method according to the invention, among those already present in the structure to be compensated. In this case the method results particularly advantageous since it does not require circuit modifications, but only the opening duly anticipated of a switch already present in the circuit.

The compensation method according to this invention shall be described hereafter in detail, referring to specific circuits, but this in not intended to limit the applicability of the method in general.

The invention shall now be described referring to the preferred realization forms, but not limitative ones, together with the attached drawings, where:
Fig. 1A shows a circuit diagram of a switched capacitor amplifier where the compensation method according to the invention is applied;
Fig. 1B shows the control phases for the circuit of Fig. 1A;
Fig. 2 shows a branch of a fully differential switched capacitor structure where the method according to the invention is applied;
Fig.3 shows the conventional control phases for the circuit of Fig. 2;
Fig. 4 shows the circuit of Fig. 2 where the compensation is carried out with the method of the present invention; and
Fig. 5 shows the timing of the control signals as involved in the method according to the invention.

In the Figures, the switches have been identified with labels representing the relevant control or phase signals, and conventionally a switch is closed when the control signal is high and vice versa.

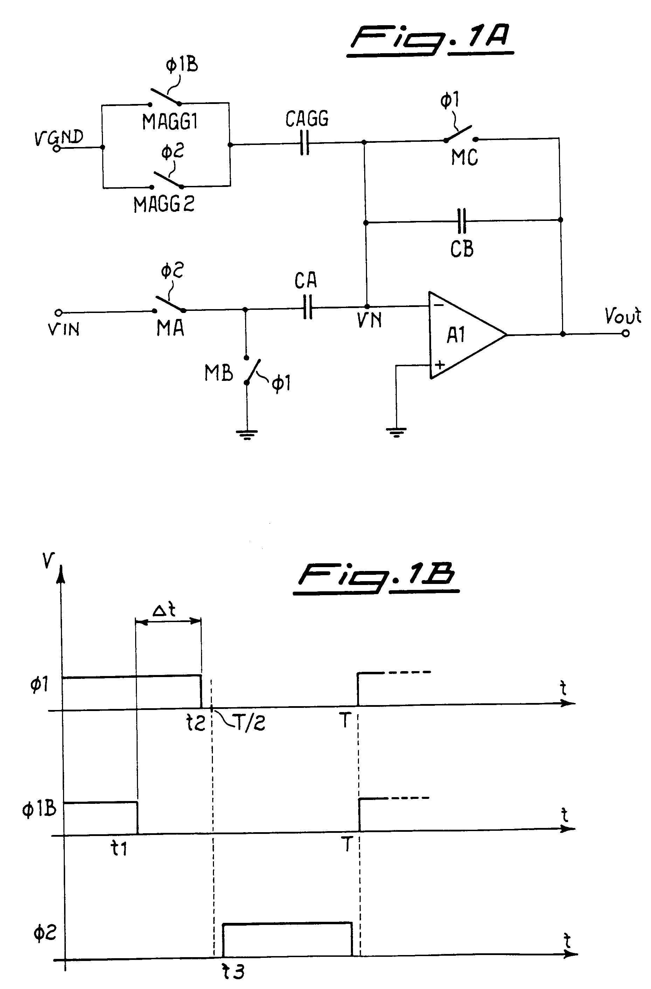

In the circuit of Fig. 1A, useful capacitors for the input signal amplification VIN are CA and CB and the useful switches are MA, MB and MC, while control phases are shown in Fig. 1B.

The function performed by the circuit shown is the one of a simple charge integrator. During the phase Φ2 the capacitor CA is connected to the input voltage VIN and the output takes the value -(CA/CB)*VIN. During the subsequent half-period, phase Φ1, CA is discharged to ground through the switch MB and the amplifier A1 is autozeroed with the closing of MC.

In the arrangement shown, the switch causing an offset error is MC. When it opens, it injects in virtual ground, node VN in Fig. 1A, a quantity of charge proportional to the auto-zero voltage of the operational amplifier A1, that is a charge proportional to the voltage at which the operational amplifier is brought when closed in unit gain configuration.

According to the invention it is involved a network made of a capacitor CAGG, of a compensation switch MAGG1 controlled by the additional phase Φ1B and of a compensation switch MAGG2 controlled by the phase Φ2. As shown on Fig. 1B, where T is the repetition period of the phases, the phase Φ1B goes to the logic level 0 (zero) at time t1 of the cycle, with an early interval Δt compared to time t2, when phase Φ1 goes to the off state.

The early opening of the compensation switch MAGG 1, which is turned off at tl, stores a compensation charge in the capacitor CAGG, the charge magnitude, as first approximation, is equal to the one that MC will inject in the VN high impedance node at t2.

The subsequent closing of the compensation switch MAGG2, at t3 in the figure, allows the compensation charge flowing towards the low impedance, drawing also the clockfeedthrough one trapped in the node VN, cancelling therefore the offset error.

To increase the method effectiveness it is recommended a good matching between the compensation switches and the clockfeedthrough switch to be compensated, in terms of transistors size and of phase signals slope.

As previsouly stated, the method can be applied also to differential structures and in some cases it can be applied without adding components to the operational amplifier to compensate.

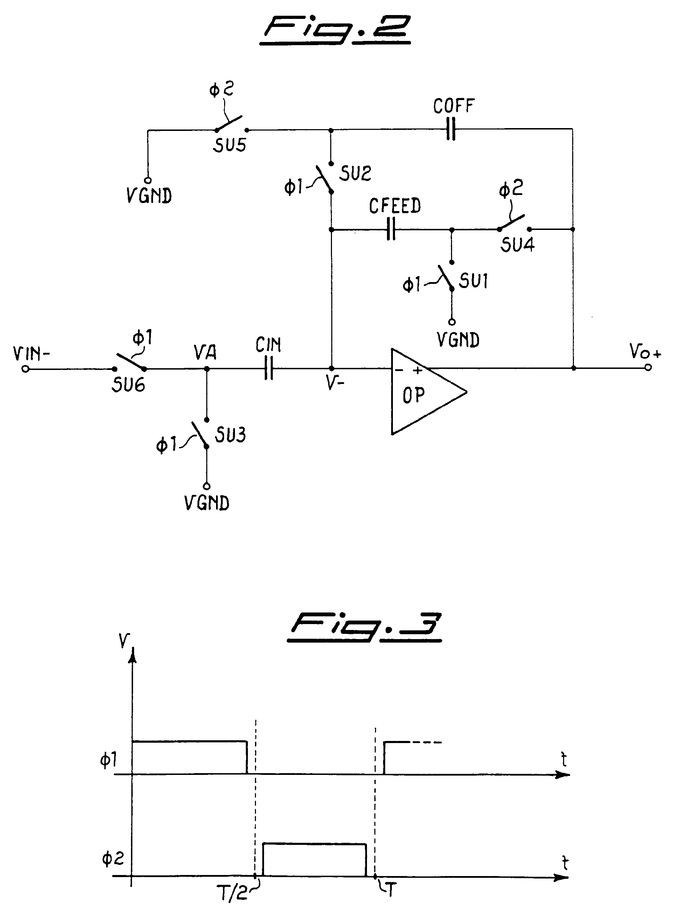

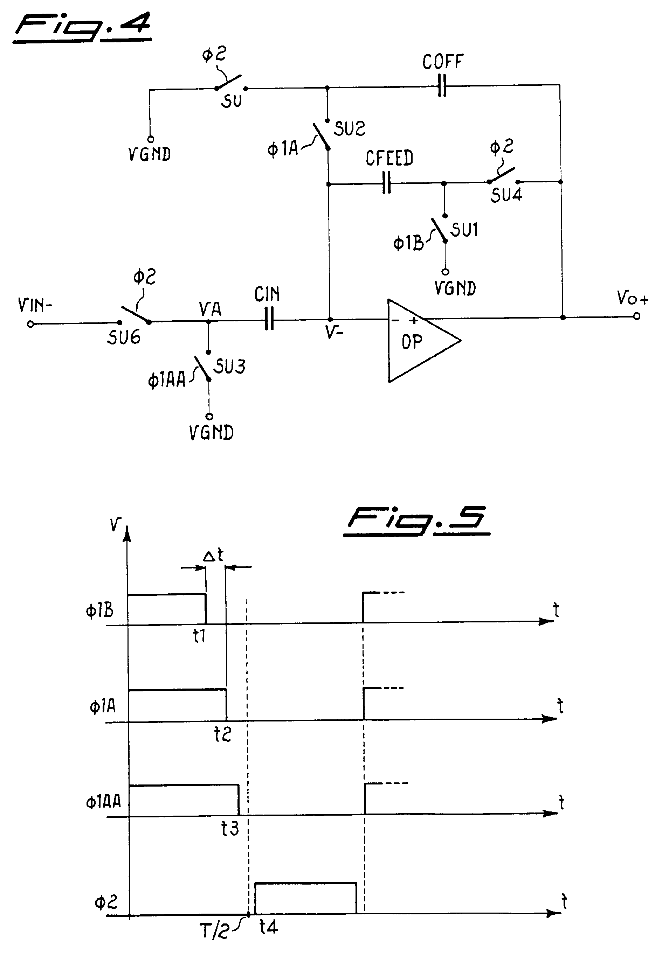

Fig. 2 shows a branch of a switched capacitor fully differential amplifier branch structure of the known type, in which the method according to the invention is profitably employed without the use of additional components. The circuit portion omitted is symmetrical with respect to the one shown and therefore it shall not be considered for sake of simplicity. Fig. 3 shows the control signals or phases Φ1 and Φ2 of switches from SU1 to SU6.

The circuit operation is summarized hereinafter. During the phase Φ1 (Φ1 at high level), capacitors CIN and CFEED are connected through switches SU3 and SU1, at a reference voltage, equal to the analogue ground voltage indicated in Fig. 2 as VGND, while the capacitor COFF, through switch SU2, performs the updated reading of the OP stage offset. During the subsequent phase Φ2, CIN is connected, through the switch SU6, to the external signal and the signal charge is injected through the feedback capacitor CFEED and the switch SU4 towards the output VO+, while COFF is now connected, through the switch SU5, to the reference voltage VGND sampling in this way the current value of the operational amplifier output performing a finit gain error compensation.

Fig. 3 shows the control phases Φ1 and Φ2, with a T period. During the transition Φ1-Φ2, the opening of the switch SU2 causes the injection of a parasitic charge in the virtual ground, originating an error voltage on V-.

During phase Φ1, the SU1 switch is biased at VGND level as well and can therefore act as compensation switch.

According to the invention, as shown in Fig. 4, the opening of the switch SU1 has been brought forward, driving this switch with a phase Φ1B shown in Fig. 5. It should be noticed that from a circuital point of view, Figures 2 and 4 are identical, while they differ for the control signals acting on the different switches.

The clockfeedthrough error compensation takes place as described below. It is assumed that the turning to the logic state 0 (zero) corresponds to SU1 opening, as it occurs for instance if this switch is made with a N channel MOS transistor. The same applies to SU2 and the relevant control phase Φ1A.

As it can be noticed in the phase diagram of Fig. 5, the phase Φ1B turns to the logic state 0 (zero) at tl, with and early interval Δt in comparison to the opening of SU2 which is controlled by the turning to the logic state 0 (zero) of phase Φ1A, taking place at t2.

During the time interval Δt, a portion of the charge is injected by SU1 on CFEED and, through the resistance in the conductive state (Ron) of SU2 still closed, on COFF. A portion of the charge coming from the conduction channel and from the capacitance coupling of the clock signal is injected in fact on the low impedance of the VGND reference.

At time t2, the opening of SU2 originates the injection of an equal quantity of parasitic charge on the capacitive node of the virtual ground V-.

Finally, at t3, SU3 is opened and, being now open the feedback path of the amplifier OP, the charge injected by SU3 accumulates only on the parasitic capacitances laying on node VA.

In the subsequent phase Φ2, when the switch SU6 is closed, it quickly flows again towards the low impedance offered by the signal source VIN-, without modifying the charge balance in capacitors CIN and CFEED, and therefore without originating any error voltage.

In order to make the compensation effective, the time interval Δt must be adequately dimensioned in such a way to enable the compensation charge to flow again through the output of the operational amplifier OP.

Being the magnitude of the considered charge small, this interval can be set at 1/2πGBW (where GBW is the Gain Band Width, i.e. the band-gain product of the operational amplifier) corresponding to a charge compensation of about 90%.

Though the compensation method according to the invention has been shown making reference to two particular cases, it is applicable in general to other switched capacitor structures, as it shall be clear to the skilled in the art.

## Claims

1. A method for the compensation of the clockfeedthrough error in a high impedance node (VN) of a switched-capacitor differential stage, the stage including an operative capacitor (CB) having a terminal thereof permanently connected with said high impedance node (VN) and one useful electronic switch (MC) in parallel with said operative capacitor (CB) for periodically short-circuiting it (auto zero),
characterized by the fact that, before the opening of said useful switch (MC), a first compensation switch (MAGG1) connecting a bias voltage (VGND) with the terminal of at least one capacitance (CAGG) having the other terminal connected to said high impedance node (VN) is closed for the injection into said at least one capacitance (CAGG) of a parasitic charge which is substantially equal and opposed to the one subsequently injected into the node (VN) upon the opening of said useful switch (MC), whereby the clockfeedthrough offset error is compensated.

2. A method as claimed in claim 1 characterized by the fact that a further compensation switch (MAGG2) is parallely connected to said first compensation switch (MAGG1), this further compensation switch (MAGG2) being closed after the closing of said useful switch (MC).

3. A method for the compensation of the clockfeedthrough error in a high impedance node (V-) of a switched-capacitor fully differential stage wherein each branch includes:
a first operative capacitor (CFEED) and a second operative capacitor (CIN) each having a terminal permanently connected with said high impedance node (V-);
a first electronic switch (SU1) for periodically connecting the other terminal of said first operative capacitor (CFEED) to a bias voltage (VGND);
characterized by the fact that each branch also includes a second electronic switch (SU2) connected to said high impedance node (V-) and to a bias voltage (VGND), the opening of which causes the clockfeedthrough error, and further characterized by the fact that the opening of said first switch (SU1) takes place before the opening of said second electronic switch (SU2) thus injecting into said first capacitor (CFEED) a parasitic charge which is substantially equal and opposed to the one subsequently injected into the node (V-) upon the opening of said second switch (SU2), whereby the clockfeedthrough offset error is compensated (Fig. 3).

## Patentansprüche

1. Verfahren zur Taktdurchführungsfehlerkompensation in einem hochohmigen Knoten einer Differentialstufe mit geschalteten Kapazitäten, wobei die Stufe einen Betriebskondensator (CB) einschließt, der über einem Anschluß permanent mit dem genannten hochohmigen Knoten (VN) und einem elektronischen Nutzschalter (MC) parallel zu dem genannten Betriebskondensator (CB) verbunden ist, um ihn periodisch kurzzuschließen (auto zero),
dadurch gekennzeichnet, daß vor dem Öffnen des genannten Nutzschalters (MC) ein erster Kompensationsschalter (MAGG1), der eine Vorspannung (VGND) mit dem Anschluß von zumindest einer Kapazitanz (CAGG) verbindet, und deren anderer Anschluß mit dem genannten hochohmigen Knoten (VN) verbunden ist, geschlossen wird für die Injektion einer parasitären Ladung in mindestens eine der Kapazitäten CAGG, wobei die parasitäre Ladung im wesentlichen gleich mit und umgekehrt zu derjenigen ist, die nachfolgend in den Knoten (VN) nach dem Öffnen des genannten Nutzschalters (MC) eingespeist wird, wodurch der Taktdurchführungsverschubfehler (offset error) kompensiert wird.

2. Verfahren nach Anspruch 1, dadurch gekennzeichnet, daß ein weiterer Kompensationsschalter (MAGG2) parallel mit dem genannten ersten Kompensationsschalter (MAGG1) verbunden ist, wobei dieser weitere Kompensationsschalter (MAGG2) nach dem Schließen des genannten Nutzschalters (MC) geschlossen wird.

3. Verfahren zur Kompensation des Taktdurchführungsfehlers in einem hochohmigen Knoten (V-) einer Volldifferentialstufe mit geschalteten Kapazitäten, in der jeder Zweig folgendes einschließt:
einen ersten Betriebskondensator (CFEED) und einen zweiten Betriebskondensator (CIN), wobei jeder durch einen Anschluß mit dem genannten hochohmigen Knoten (V-) verbunden ist;
einen ersten elektronischen Schalter (SU1) zur periodischen Verbindung des anderen Anschlusses des genannten ersten Betriebskondensators (CFEED) mit einer Vorspannung (VGND);
dadurch gekennzeichnet, daß jeder Zweig auch einen zweiten elektronischen Schalter (SU2) einschließt, der mit dem genannten hochohmigen Knoten (V-) und mit einer Vorspannung (VGND) verbunden ist, und dessen Öffnen den Taktdurchführungsfehler hervorruft, und darüber hinaus gekennzeichnet, daß das Öffnen des genannten zweiten elektronischen Schalters (SU2) so in den genannten ersten Kondensator (CFEED) eine parasitäre Ladung eingibt, die im wesentlichen gleich mit und umgekehrt zu derjenigen ist, die nachfolgend in den Knoten (V-) eingespeist wird, und zwar nach dem Öffnen des genannten zweiten Schalters (SU2), wodurch der Taktdurchführungsverschubfehler kompensiert wird (Abbildung 3).

## Revendications

1. Procédé pour la compensation de l'erreur de clockfeedthrough dans un noeud d'impédance élevée (VN) d'un stade différentiel de condensateurs commutés, qui comprend un condensateur opérationnel (CB) ayant un de ses connecteurs relié en permanence au dit noeud d'impédance élevée (VN) et un interrupteur électronique utile (MC) en parallèle avec le dit condensateur opérationnel (CB) pour le court-circuiter périodiquement (auto-zero),
caractérisé en ce que, avant l'ouverture du dit interrupteur utile (MC), un premier interrupteur utile (MAGG1) reliant une tension polarisée (VGND) au connecteur d'au moins une capacitance (CAGG) ayant l'autre connecteur relié au dit noeud d'impédance élevée (VN) est fermé pour l'injection dans la dite au moins une capacitance (CAGG) d'une charge parasite, qui est considérablement égale et opposée à celle injectée successivement dans le noeud (VN) après l'ouverture du dit interrupteur utile (MC), au moyen de laquelle l'erreur de traversée de synchronisation (clockfeedthrough offset error) est compensé.

2. Un procédé comme sous 1, caractérisé en ce que un interrupteur de compensation ultérieur (MAGG2) est relié en parallèle avec le dit premier interrupteur de compensation (MAGG1), cet interrupteur de compensation ultérieur MAGG2) étant fermé après la fermeture du dit interrupteur utile MC).

3. Un procédé pour la compensation de l'erreur de traversée de synchronisation dans un noeud d'impédance élevée (V-) d'un stade entièrement différentiel, où chaque branche comprend:
un premier condensateur opérationnel (CFEED) et un deuxième condensateur opérationnel (CIN), chacun ayant en permanence un connecteur relié au dit noeud d'impédance élevée (V-);
un premier interrupteur électronique (SU1) pour relier périodiquement l'autre connecteur du dit premier condensateur opérationnel (CFEED) à une tension polarisée (VGND);
caractérisé en ce que chaque branche comprend aussi un deuxième interrupteur électronique (SU2) relié au dit noeud d'impédance élevée (V-) et à une tension polarisée (VGND), dont l'ouverture cause l'erreur de traversée de synchronisation, et en outre caractérisé en ce que l'ouverture du dit premier interrupteur (SU1) a lieu avant l'ouverture du dit deuxième interrupteur électronique (SU2) injectant de cette manière dans le dit premier condensateur (CFEED) une charge parasite, qui est considérablement égale et opposée à celle injectée successivement dans le noeud (V-) après l'ouverture du dit deuxième interrupteur (SU2), au moyen de laquelle l'erreur de traversée de synchronisation est compensé.
